# EUROPÄISCHE PATENTSCHRIFT

(11) **EP 0 674 383 B1**
(45) Veröffentlichungstag und Bekanntmachung des Hinweises auf die Patenterteilung: **24.10.2001**
(21) Anmeldenummer: 95200685.6
(22) Anmeldetag: 21.03.1995
(51) Int. Cl.: H03F 3/19

(54) **Schaltungsanordnung zum Liefern eines Signalwechselstromes**
Circuit arrangement for providing an alternating current signal
Circuit pour fournir un signal de courant alternatif

(30) Priorität: 26.03.1994 DE 4410560
(43) Veröffentlichungstag der Anmeldung: 27.09.1995
(73) Patentinhaber: Philips Corporate Intellectual Property GmbH, 52064 Aachen (DE); Koninklijke Philips Electronics N.V., 5621 BA Eindhoven (NL)
(72) Erfinder: Holtvoeth, Knud, D-20097 Hamburg (DE); Wichern, Andreas, D-20097 Hamburg (DE)
(74) Vertreter: Peters, Carl Heinrich, Dipl.-Ing.

(56) Entgegenhaltungen:
- JP-A- 3 093 307
- US-A- 3 564 438
- US-A- 4 525 682
- IEEE JOURNAL OF SOLID-STATE CIRCUITS, Bd. 26, Nr. 10, Oktober 1991 NEW YORK US, Seiten 1457-1460, XP 000264312 H. PARZHUBER W. STEINHAGEN 'AN ADAPTIVE BIASING ONE-STAGE CMOS OPERATIONAL AMPLIFIER FOR DRIVING HIGH CAPACITIVE LOADS'
- REVUE DE PHYSIQUE APPLIQUEE, Bd. 20, Nr. 7, Juli 1985 PARIS FR, Seiten 465-482, F. BAILLIEU ET R. HERMEL 'L'AMPLIFICATEUR CMOS DANS LES CIRCUITS CAPACIT S COMMUT ES'

## Beschreibung

Die Erfindung bezieht sich auf eine Schaltungsanordnung gemäß dem Oberbegriff des unabhängigen Anspruchs 1.

Aus der Veröffentlichung DE 35 90 480 T1 ist ein Verstärker für ein Hochfrequenzsignal bekannt, in dem eine integrierte Schaltung ausgebildet ist, die wenigstens zwei Stufen von gleichstromgekoppelten, emittergeerdeten Verstärkern enthält. Ein Emitterwiderstand ist zwischen einen Emitter des emittergeerdeten Verstärkers in einer zweiten oder nachfolgenden Stufe und eine Erdung geschaltet. Ein Anschluß außerhalb der integrierten Schaltung ist derart vorgesehen, daß er über eine Verbindungsleitung mit dem Emitter des emittergeerdeten Verstärkers in der zweiten oder nachfolgenden Stufe verbunden ist. Zwischen dem vorgenannten Anschluß und der externen Erdung ist ein Filterkreis angeordnet, der eine Induktivität der Verbindungsleitung enthält und eine niedrige Impedanz für eine besondere Frequenz entwickelt. Damit soll ein Hochfrequenzverstärker gebildet werden, der stabil arbeiten kann, ohne daß ein Schwingungsphänomen verursacht wird. Durch die Ausbildung eines Filterkreises ist dieser bekannte Verstärker jedoch nur sehr schmalbandig einsetzbar.

Aus der US-PS 3 810 256 ist ein breitbandiger Transistorverstärker bekannt, der einen Gegenkopplungskreis für maximale Gegenkopplung sowie einen Schaltkreis enthält, mit dem in der Art einer Gegenkopplung ausschließlich die Störanteile, die im Ausgangssignal des Verstärkers auftreten, zum Zwecke einer zusätzlichen Reduktion rückgekoppelt werden. Dazu umfaßt der Transistorverstärker eine Kaskadenanordnung von zwei Impedanzen deren gemeinsamer Verbindungspunkt mit dem Eingang eines Phaseninverters verbunden ist, welcher die Störanteile in Gegenphase in den Ausgangskreis des Verstärkers einspeist. Auch in dieser Schaltungsanordnung ist in der Emitterverbindung einer Verstärkerstufe ein gedämpfter Parallelschwingkreis vorgesehen, durch den die Verstärkung bei hohen Frequenzen beeinflußt werden soll. Auch hier wird jedoch keine breitbandige Wirkung erhalten.

Aus der EP-A-264 631 ist ein rückgekoppelter, frequenzkompensierter Transistorverstärker bekannt, der eine relativ große Bandbreite und relativ weite Phasen- und Verstärkungs-Grenzen aufweist, unabhängig vom Gegenwirkleitwert der Transistoren im Verstärker. Die bekannte Schaltung enthält einen Steilheitsverstärker und eine Verstärkerstufe. Der Steilheitsverstärker liefert an die Verstärkerstufe ein Eingangssignal, und die Verstärkerstufe erzeugt eine verstärkte Nachbildung dieses Eingangssignals. Ein Rückkopplungskondensator ist zwischen dem Ausgang und dem Eingang der Verstärkerstufe angeordnet und bewirkt eine Verminderung der Schleifenverstärkung um 6 Dezibel pro Oktave mit zunehmender Frequenz. Der Kondensator bildet einen Signalpfad für Restanteile des Eingangssignals, so daß diese Restanteile am Ausgang des Verstärkers in im wesentlichen der gleichen Phase auftreten wie das Ausgangssignal der Zwischenfrequenz.

Bei Schaltungsanordnungen der gattungsgemäßen Art zeigt sich bei Signalwechselströmen hoher Frequenzen ein deutlicher Einfluß parasitärer Impedanzen auf die Amplitude der zu liefernden Signalwechselströme. Weist insbesondere eine solche Schaltungsanordnung einen Ausgangsstrompfad auf, der einseitig mit einem Bezugspotential, z.B. Masse, gekoppelt ist, so stellt selbst eine kurze Leitungsverbindung zwischen dem Ausgangsstrompfad und dem Bezugspotential eine parasitäre Induktivität dar, über der bei höheren Frequenzen eine merkliche Spannung entsteht, die eine Gegenkopplung bewirkt, durch die die Amplitude des Signalwechselstromes deutlich vermindert werden kann.

Aus der US-PS 3,564,438 geht eine Signalübersetzungsschaltung hervor mit einem ersten und einem zweiten Paar von Halbleiteranordnungen, die angepaßte Leitungscharakteristiken aufweisen. Diese Signalübersetzungsschaltung ist zum Liefern eines Ausgangssignals vorgesehen, welches eine Differenz zwischen zwei Eingangssignalen repräsentiert, wobei das Ausgangssignal bezogen ist auf einen vorbestimmten Gleichspannungspegel, der im wesentlichen unabhängig von den Gleichspannungspegeln der Eingangssignale ist. Die beiden Paare der Halbleiteranordnungen werden mit den Eingangssignalen gespeist. Das erste Eingangssignal wird über eine Impedanz an einen Verbindungspunkt zwischen der ersten Halbleiteranordnung und der zweiten Halbleiteranordnung des ersten Paares und der zweiten Halbleiteranordnung des zweiten Paares eingespeist. Das zweite Eingangssignal wird über eine weitere Impedanz in eine Verbindung zwischen der ersten und der zweiten Halbleiteranordnung des zweiten Paares gespeist. Das Ausgangssignal, welches eine Funktion der Differenz zwischen den Eingangssignalen ist, wird über eine Ausgangsimpedanz abgegriffen, die mit der ersten Halbleiteranordnung des ersten Paares gekoppelt ist.

Die aus diesem Dokument entnehmbare Schaltungsanordnung dient dazu, eine Ausgangswechselspannung zu liefern, deren Gleichspannungspegel unabhängig von den Gleichspannungspegeln der Eingangssignale ist. Die Schaltung ist insbesondere vorgesehen für integrierte Schaltkreise, in denen die Unterbringung einer Koppelkapazität, wie sie üblicherweise zum Abtrennen von Gleichspannungspegeln vorgesehen wird, nicht möglich ist. Damit soll die Notwendigkeit umgangen werden, eine solche Koppelkapazität außerhalb einer integrierten Schaltungsanordnung als diskretes Bauteil anzuordnen. Ein Hinweis auf etwaige Schwierigkeiten mit parasitären Elementen bei höheren Frequenzen ist diesem Dokument nicht zu entnehmen, auch nicht bezüglich parasitärer Induktivitäten.

Aus der JP-A-03093307 geht ein Schaltkreis hervor, der es ermöglichen soll, ein zugeführtes Signal mit rechteckiger Wellenform ohne parallele Verbindungen mehrerer Bonddrähte wieder auszugeben. Dies wird gemäß den Ausführungen der JP-A-03093307 dadurch bewirkt, daß ein Signal, welches an einem Emitterfolgertransistor durch Serienresonanz erzeugt wird, durch ein invertiertes Signal ausgelöscht wird. Diese Serienresonanz entsteht dabei durch eine Induktivität eines Bonddrahtes zwischen einem Stromversorgungsanschluß eines LSI und einem Stromversorgungsanschluß einer integrierten Schaltung und einer Kapazität zwischen Basiselektroden und Masse der Transistoren eines Differenzverstärkers.

Aus der JP-A-03093307 ist jedoch nicht zu entnehmen, wie eine parasitäre Induktivität in einem Ausgangsstrompfad kompensiert werden soll, in dem ein Ausgangssignalwechselstrom geführt wird. Vielmehr werden Ausgangsströme bei der in der JP-A-03093307 gezeigten Schaltungsanordnung von den Kollektoranschlüssen der dortigen Transistoren Q3 und Q4 über Induktivitäten L1 und L2 an Ausgangsanschlüsse 1 bzw. 2 geführt, zwischen denen eine Ausgangsspannung abgegriffen werden kann. Eine Kompensation etwaiger - in der JP-A-03093307 jedoch nicht angesprochener - Wirkungen der dortigen Induktivitäten L1 und L2 ist jedoch aus dieser Druckschrift nicht ersichtlich.

Die Erfindung hat die Aufgabe, eine Schaltungsanordnung der eingangs genannten Art in der Weise auszubilden, daß parasitäre Induktivitäten im Ausgangsstrompfad die Amplitude des Signalwechselstromes nicht beeinflussen.

Diese Aufgabe wird nach der Erfindung bei einer Schaltungsanordnung der gattungsgemäßen durch die kennzeichnenden Merkmale des unabhängigen Anspruchs 1 gelöst.

Wie bereits erwähnt führt eine parasitäre Induktivität im Ausgangsstrompfad, insbesondere in einer Kopplung desselben mit einem Bezugspotential, bei hohen Frequenzen zu einer wirksamen Gegenkopplungsspannung, durch die der Signalwechselstrom mit steigender Frequenz stark zunehmend geschwächt wird. Zwar sind Maßnahmen bekannt, derartige parasitäre Induktivitäten klein zu halten, jedoch bedingt dies vielfach einen hohen Schaltungsaufwand, dessen Nutzen meist nur sehr begrenzt ist. Wird die Schaltungsanordnung zum Liefern des Signalwechselstromes auf einem Halbleiterkörper als integrierte Schaltung aufgebaut, entstehen merkbare parasitäre Induktivitäten bereits durch die Kontaktierung vom Halbleiterkörper zum außerhalb der integrierten Schaltung vorhandenen Bezugspotential, beispielsweise Masse. Eine Verringerung der parasitären Induktivitäten dieser Zuleitung ist nur bedingt und mit hohem Aufwand beispielsweise durch Parallelschalten sehr vieler Bonddrähte zwischen dem Halbleiterkörper und einem Lötanschluß oder einer Leiterbahn möglich. Solche parallelgeschalteten Bonddrähte sind jedoch aufwendig herzustellen und benötigen viel Platz, der in keinem wirtschaftlichen Verhältnis mehr zur Stromstärke der tatsächlich zu liefernden Signalwechselströme steht.

Die Erfindung schafft hier in der Weise Abhilfe, daß die eine Gegenkopplungsspannung hervorrufenden Ströme in der parasitären Induktivität durch einen Kompensationswechselstrom zumindest teilweise überlagert und unwirksam gemacht werden. Dieser Kompensationswechselstrom wird bevorzugt gegenphasig aus Strömen bzw. Spannungen innerhalb der Schaltungsanordnung hergeleitet, aus denen auch der von der Schaltungsanordnung letztendlich zu liefernde Signalwechselstrom abgeleitet wird. Dadurch ist vor allem eine einfache und breitbandige Kompensation der unerwünschten Gegenkopplung durch die parasitäre Induktivität gewährleistet. Das Übertragungsverhalten der Schaltungsanordnung wird somit in weiten Frequenzbereichen verbessert. Aufwendige Konstruktionen für die Kopplung des Ausgangsstrompfades mit dem Bezugspotential können entfallen.

Vorteilhaft umfaßt der Ausgangsstrompfad der erfindungsgemäßen Schaltungsanordnung einen Hauptstrompfad eines ersten Ausgangstransistors. Dieser stellt die Ausgangsstufe der Schaltungsanordnung zum Liefern des Signalwechselstromes dar und kann insbesondere als bipolarer Transistor in Emitterschaltung ausgebildet sein. Die durch die Erfindung unerwirksam gemachte parasitäre Induktivität befindet sich dann in der Kopplung zwischen dem Emitter dieses ersten Ausgangstransistors und einem das Bezugspotential, z.B. Masse, führenden Leiter.

In einer Weiterbildung weist die Kompensationsanordnung der erfindungsgemäßen Schaltungsanordnung einen zweiten Ausgangstransistor auf, dessen Hauptstrompfad mit einem seiner Enden an den ersten Verbindungspunkt und mit seinem zweiten Ende an einen Steueranschluß des ersten Ausgangstransistors angeschlossen ist. Der erste und der zweite Ausgangstransistor können somit über ihre Hauptstrompfade Ströme in die parasitäre Induktivität einspeisen. Dabei sind vorzugsweise der erste und der zweite Ausgangstransistor mit gegenphasigen Wechselstrom-Steuersignalen beaufschlagbar. Bei einer derartigen Ansteuerung der Ausgangstransistoren wird die Aussteuerung des ersten Ausgangstransistors an dessen Steueranschluß durch den gegenphasig ausgesteuerten zweiten Ausgangstransistor verstärkt, während gleichzeitig gegenphasige und somit einander kompensierende Wechselstromanteile von den Ausgangstransistoren in die parasitäre Induktivität gespeist werden. Die an dieser parasitären Induktivität auftretenden Spannungsanteile mit der Frequenz des Signalwechselstromes werden dadurch vermindert oder ausgelöscht. Dadurch wird der Effekt der Gegenkopplung unterbunden.

Die gegenphasigen Wechselstrom-Steuersignale, mit denen der erste und der zweite Ausgangstransistor beaufschlagbar sind, können vorteilhaft von gegenphasig gespeisten Ausgängen einer gemeinsamen Signalquelle abgeleitet werden. Als derartige Signalquelle dient zum Beispiel ein Differenzverstärker mit einem invertierenden und einem nicht invertierenden Ausgang. An diesen Ausgängen des Differenzverstärkers stehen die benötigten gegenphasigen Wechselstrom-Steuersignale ohne zusätzlichen Schaltungsaufwand zur Verfügung.

Nach einer anderen Weiterbildung ist die erfindungsgemäße Schaltungsanordnung derart ausgestaltet, daß der erste Ausgangstransistor als Ausgangszweig einer ersten Stromspiegelanordnung fungiert, die weiterhin
- einen ersten Eingangstransistor, dessen Steueranschluß mit dem Steueranschluß des ersten Ausgangstransistors und dessen Hauptstrompfad einseitig mit dem ersten Verbindungspunkt verbunden ist,
- eine erste Gleichstromquelle zwischen dem Steueranschluß des ersten Ausgangstransistors und dem ersten Verbindungspunkt,
- eine zweite Gleichstromquelle zum Speisen eines (zweiten) Gleichstromes über einen zweiten Verbindungspunkt in den Hauptstrompfad des ersten Eingangstransistors sowie
- einen ersten Treibertransistor aufweist, dessen Hauptstrompfad einseitig mit dem Steueranschluß des ersten Ausgangstransistors verbunden ist und dessen mit dem zweiten Verbindungspunkt verbundenem Steueranschluß eines der Wechselstrom-Steuersignale zuleitbar ist,
und daß der zweite Ausgangstransistor als Ausgangszweig einer zweiten Stromspiegelanordnung fungiert, deren Aufbau mit dem der ersten Stromspiegelanordnung übereinstimmt, wobei an einem Steueranschluß eines dem ersten Treibertransistor entsprechenden zweiten Treibertransistors das zweite (gegenphasige) der Wechselstrom-Steuersignale zuleitbar ist.

Bei dieser Ausgestaltung wird die Kompensationsanordnung durch die zweite Stromspiegelanordnung gebildet. Diese liefert über ihren (zweiten) Ausgangstransistor einerseits einen Kompensationswechselstrom an die parasitäre Induktivität und steuert andererseits den (ersten) Ausgangstransistor der ersten Stromspiegelanordnung aus. Die übereinstimmende Auslegung der beiden Stromspiegelanordnungen ermöglicht dabei ohne weitere Maßnahmen eine Ansteuerung mit gegenphasigen Wechselstrom-Steuersignalen gleicher Amplituden.

Ein Ausführungsbeispiel der Erfindung ist in der Zeichnung dargestellt und wird im nachfolgenden näher erläutert. Es zeigen:
- Fig. 1: ein Beispiel für eine gattungsgemäße Schaltungsanordnung zum Liefern eines Signalwechselstromes ohne Kompensationsanordnung und
- Fig. 2: die Schaltungsanordnung aus dem Beispiel von Fig. 1 nach Hinzufügen der Kompensationsanordnung.

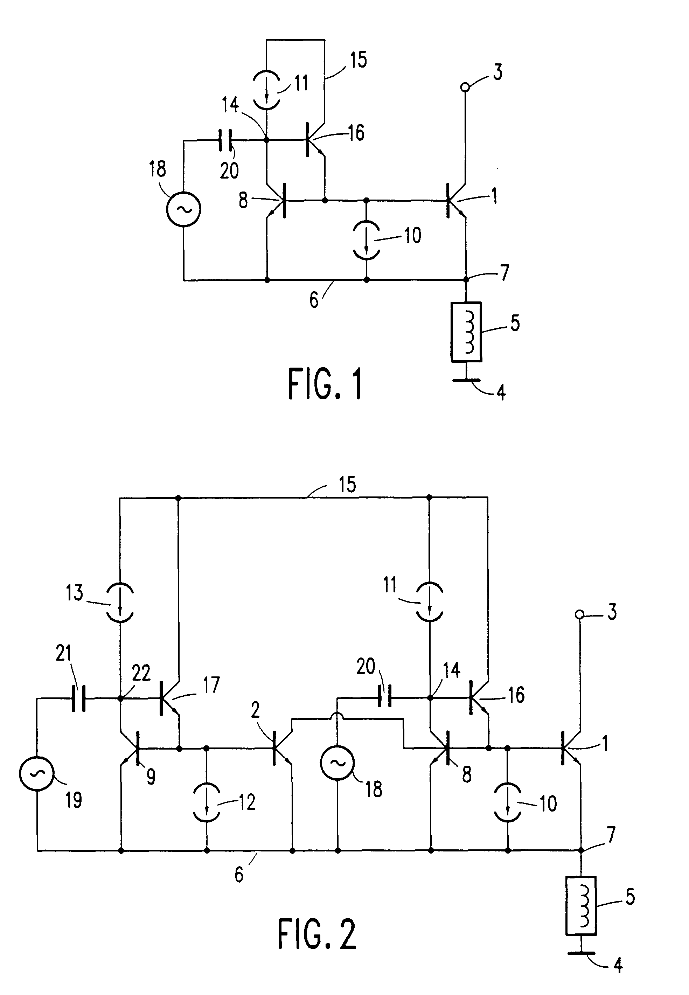

In Fig. 1 ist mit dem Bezugszeichen 1 ein erster Ausgangstransistor bezeichnet, der als bipolarer Transistor ausgebildet ist und dessen Hauptstrompfad zwischen seinem Kollektor- und seinem Emitteranschluß Teil eines Ausgangsstrompfades zwischen einem Ausgangsanschluß 3 und einer ein Bezugspotential führenden Leiteranordnung, zum Beispiel Masse 4, darstellt. Am Ausgangsanschluß 3 kann der Schaltungsanordnung nach Fig. 1 ein Signalwechselstrom entnommen werden.

Der Ausgangsstrompfad über den Hauptstrompfad des ersten Ausgangstransistors 1 ist mit Masse 4 über eine parasitäre Induktivität 5 gekoppelt. Die parasitäre Induktivität 5 wird gebildet durch eine Zuleitung zwischen Masse 4 und einem schaltungsinternen Sammelleiter 6, der beispielsweise gebildet ist durch eine Masseverbindung in einer auf einem Halbleiterkörper integrierten Schaltung. Die parasitäre Induktivität 5 wird dann gebildet durch einen Anschluß des schaltungsinternen Sammelleiters 6 auf dem Halbleiterkörper an die das Massepotential führende Leiteranordnung 4 außerhalb der integrierten Schaltung, d.h. zum Beispiel die Gerätemasse. Der Wert der parasitären Induktivität 5 kann dabei bestimmt werden durch die interne Leitungsführung auf dem Halbleiterkörper, durch Bonddrähte vom Halbleiterkörper zum externen Anschluß der integrierten Schaltung oder auch durch externe Leiterbahnen. Der Hauptstrompfad des ersten Ausgangstransistors 1 ist über dessen Emitteranschluß in einem ersten Verbindungspunkt 7 mit der parasitären Induktivität 5 verbunden.

Im Beispiel nach Fig. 1 fungiert der erste Ausgangstransistor 1 als Ausgangszweig einer ersten Stromspiegelanordnung, die weiterhin einen ersten Eingangstransistor 8 umfaßt, der ebenfalls als bipolarer Transistor ausgebildet ist und dessen Steueranschluß - d.h. dessen Basisanschluß - mit dem Steueranschluß (Basisanschluß) des ersten Ausgangstransistors verbunden ist. Über den Emitteranschluß des ersten Eingangstransistors 8 ist dessen Hauptstrompfad einseitig mit dem ersten Verbindungspunkt 7 verbunden. Zwischen die Verbindung der Steueranschlüsse des ersten Ausgangstransistors 1 und des ersten Eingangstransistors 8 einerseits und den ersten Verbindungspunkt 7 bzw. den schaltungsinternen Sammelleiter 6 andererseits ist eine erste Gleichstromquelle 10 eingefügt. Eine zweite Gleichstromquelle 11 zum Speisen eines zweiten Gleichstromes über einen zweiten Verbindungspunkt 14 in den Hauptstrompfad des ersten Eingangstransistors 8 ist einerseits mit dem Kollektoranschluß dieses ersten Eingangstransistors 8 verbunden, der den zweiten Verbindungspunkt 14 bildet, und andererseits mit einem Speisespannungsanschluß 15. Die erste und die zweite Gleichstromquelle 10, 11 dienen der Arbeitspunkteinstellung der ersten Stromspiegelanordnung.

Die erste Stromspiegelanordnung umfaßt weiterhin einen ersten Treibertransistor 16, der im Beispiel nach Fig. 1 ebenfalls als bipolarer Transistor ausgebildet ist und dessen Hauptstrompfad einseitig mit dem Steueranschluß des ersten Ausgangstransistors 1 (über den Emitteranschluß des ersten Treibertransistors 16) verbunden ist und andererseits (über den Kollektoranschluß des ersten Treibertransistors 16) an den Speisespannungsanschluß 15 angeschlossen ist. Der Steueranschluß (hier Basisanschluß) des ersten Treibertransistors 16 ist mit dem zweiten Verbindungspunkt 14 verbunden. Über den Hauptstrompfad des ersten Treibertransistors 16 werden die Basisströme des ersten Ausgangstransistors 1 und des ersten Eingangstransistors 8 sowie der Gleichstrom der ersten Gleichstromquelle 10 aus dem Speisespannungsanschluß 15 geliefert.

Dem ersten Treibertransistor 16 ist über den zweiten Verbindungspunkt 14 ein erstes Wechselstrom-Steuersignal zuleitbar. Dieses wird von einer ersten Wechselstrom-Steuersignalquelle 18 geliefert und über einen ersten Koppelkondensator 20 dem zweiten Verbindungspunkt 14 zugeleitet. Über den als Emitterfolger wirkenden ersten Treibertransistor 16 steuert das erste Wechselstrom-Steuersignal den ersten Ausgangstransistor 1 und damit den Signalwechselstrom am Ausgangsanschluß 3. Die übrigen Schaltungselemente bis auf die parasitäre Induktivität 5 wirken in erster Linie nur auf die Gleichstrom-Aussteuerung und können daher für die Beschreibung des Wechselstromverhaltens der Schaltungsanordnung außer acht gelassen werden. Der Signalwechselstrom am Ausgangsanschluß 3, der den Hauptstrompfad des ersten Ausgangstransistors 1 und die parasitäre Induktivität 5 durchfließt, ruft an der parasitären Induktivität 5 eine Spannung hervor, durch die das erste Wechselstrom-Steuersignal bzw. die davon hervorgerufene Wechselspannung am Steueranschluß des ersten Ausgangstransistors 1 insbesondere bei hohen Frequenzen eine wirksame Gegenkopplung erfährt. Dadurch wird die Amplitude des Signalwechselstromes am Ausgangsanschluß 3 stark bedämpft.

In einem Versuch hat sich für die parasitäre Induktivität 5 einer Zuleitung einer auf einem Halbleiterkörper integrierten Schaltung ein Induktivitätswert von 2 nH ergeben. Dieser Induktivitätswert liefert z.B. bei einer Frequenz von 915 MHz einen Blindwiderstand von 11,5 Ohm.

Fig. 2 zeigt eine Ausführungsform einer erfindungsgemäßen Schaltungsanordnung, bei der durch Hinzufügen einer Kompensationsanordnung zu den Elementen der Fig. 1 der Einfluß der parasitären Induktivität 5 kompensiert wird. Zusätzlich zu den zu Fig. 1 bereits erläuterten und wieder mit denselben Bezugszeichen versehenen Elementen enthält die Schaltungsanordnung nach Fig. 2 in der Kompensationsanordnung eine zweite Stromspiegelanordnung, die einen zweiten Ausgangstransistor 2 und einen zweiten Eingangstransistor 9 umfaßt. Der Hauptstrompfad des zweiten Ausgangstransistors 2 bildet den Ausgangszweig dieser zweiten Stromspiegelanordnung. Die Steueranschlüsse des zweiten Ausgangstransistors 2 und des zweiten Eingangstransistors 9 sind miteinander sowie mit einem Anschluß einer dritten Gleichstromquelle 12 und mit dem Emitteranschluß eines zweiten Treibertransistors 17 verbunden. Die Emitteranschlüsse der ebenfalls als bipolare Transistoren ausgebildeten und in ihrer Dimensionierung dem ersten Ausgangstransistor 1 bzw. dem ersten Eingangstransistor 8 entsprechenden Transistoren 2, 9 der zweiten Stromspiegelanordnung sind mit dem schaltungsinternen Sammelleiter 6 an den ersten Verbindungspunkt 7 angeschlossen, an den auch ein zweiter Anschluß der dritten Gleichstromquelle 12 geführt ist. Der Kollektoranschluß des zweiten Treibertransistors 17 sowie ein Anschluß einer vierten Gleichstromquelle 13 sind mit dem Speisespannungsanschluß 15 verbunden. Ein zweiter Anschluß der vierten Gleichstromquelle 13 ist in einem dritten Verbindungspunkt 22 mit dem Kollektoranschluß des zweiten Eingangstransistors 9, einem Steueranschluß des zweiten Treibertransistors 17 und einem Anschluß eines zweiten Koppelkondensators 21 verbunden. Über diesen zweiten Koppelkondensator, der wiederum mit einer zweiten Wechselstrom-Steuersignalquelle 19 verbunden ist, wird dem dritten Verbindungspunkt 22 ein zweites Wechselstrom-Steuersignal zugeleitet, welches vorzugsweise in Frequenz und Amplitude mit dem ersten Wechselstrom-Steuersignal übereinstimmt, zu diesem jedoch gegenphasig schwingt. Vorzugsweise können die Wechselstrom-Steuersignalquellen 18, 19 gegenphasige Ausgänge (invertierend bzw. nicht invertierend) eines Operationsverstärkers oder dergleichen sein, was in Fig. 2 der Einfachheit halber jedoch nicht dargestellt ist. Über den Kollektoranschluß des zweiten Ausgangstransistors 2 ist dessen Hauptstrompfad, der den Ausgangszweig der zweiten Stromspiegelanordnung bildet, mit dem Steueranschluß des ersten Ausgangstransistors 1 verbunden.

Bei der Schaltungsanordnung nach Fig. 2 wird gegenüber der Schaltungsanordnung nach Fig. 1 ein überwiegender Teil des Ruhestroms, d.h. des für die Arbeitspunkteinstellung der ersten Stromspiegelanordnung fließenden Gleichstromes durch den Hauptstrompfad des ersten Treibertransistors 16, nicht mehr durch die erste Gleichstromquelle 10 geführt, sondern durch den zweiten Ausgangstransistor 2. In diesem zweiten Ausgangstransistor 2 wird dieser Teil des Ruhestroms des ersten Treibertransistors 16 dazu benutzt, die Aussteuerung des ersten Ausgangstransistors 1 zu verbessern. Durch diese Maßnahme wird zunächst ein nur sehr geringfügiger zusätzlicher Strom aus dem Speisespannungsanschluß 15 entnommen.

Der in den Hauptstrompfad des zweiten Ausgangstransistors 2 geleitete Teil des Ruhestroms des ersten Treibertransistors 16 wird im zweiten Ausgangstransistor 2 durch die zweite Wechselstrom-Steuersignalquelle 19 gegenphasig zum ersten Ausgangstransistor 1 ausgesteuert. Da auch in der zweiten Stromspiegelanordnung für das Wechselstromverhalten im wesentlichen nur der (zweite) Ausgangstransistor bedeutsam ist, kann das Wechselstromverhalten der gesamten Schaltungsanordnung nach Fig. 2 an einer vereinfachten Schaltungsanordnung erläutert werden, die nur noch die beiden Ausgangstransistoren 1, 2 und die parasitäre Induktivität 5 umfaßt. Anhand eines derartig vereinfachten Wechselstromschaltbildes läßt sich erkennen, daß durch eine gegenphasige Aussteuerung an den Steueranschlüssen der Ausgangstransistoren 1, 2 einerseits die Ansteuerung am Steueranschluß des ersten Ausgangstransistors 1 verstärkt und damit der Signalwechselstrom am Ausgangsanschluß 3 vergrößert werden kann, andererseits über die Emitteranschlüsse der Ausgangstransistoren 1 und 2 jetzt gegenphasige Ströme an die parasitäre Induktivität 5 weitergeleitet werden, die sich hier wenigstens zum Teil gegenseitig auslöschen. Dadurch wird die die Gegenkopplung verursachende Spannung an der parasitären Induktivität 5 ebenfalls wenigstens teilweise ausgelöscht und somit der Signalwechselstrom am Ausgangsanschluß 3 nicht mehr bedämpft.

In einer praktischen Ausführung konnte auf diese Weise mit nur einer unwesentlich vergrößerten Stromaufnahme durch die Kompensationsanordnung die Stromstärke des Signalwechselstromes am Ausgangsanschluß 3 bei einer bestimmten Signalfrequenz in etwa vervierfacht werden. Umgekehrt läßt sich für eine bestimmte Amplitude des Signalwechselstromes die erforderliche Treiberleistung und damit insgesamt der Energieverbrauch und die Erwärmung der Schaltungsanordnung verringern, ohne daß der Konstruktionsaufwand für die Anschlüsse der Schaltungsanordnung an externe Leiteranordnungen erhöht werden muß.

## Patentansprüche

1. Schaltungsanordnung mit einem Ausgangsstrompfad, der zwischen einem Ausgangsanschluß (3) und einer ein Bezugspotential führenden Leiteranordnung (4) gekoppelt ist und einen Hauptstrompfad eines ersten Ausgangstransistors (1) umfaßt zum Liefern eines Signalwechselstromes an den Ausgangsanschluß (3),
**dadurch gekennzeichnet, daß** eine Kompensationsanordnung (2,9,12,13,17,19,21) vorgesehen ist, durch die der Einfluß einer parasitären Induktivität (5) in der Kopplung zwischen dem Ausgangsstrompfad und der das Bezugspotential führenden Leiteranordnung (4) dadurch kompensiert wird, daß einem ersten Verbindungspunkt (7) zwischen dem Ausgangsstrompfad und der parasitären Induktivität (5) ein Kompensationswechselstrom zuführbar ist, der gegenphasig und von wenigstens im wesentlichen gleicher Größe wie der Signalwechselstrom ist.

2. Schaltungsanordnung nach Anspruch 1,
**dadurch gekennzeichnet, daß** der erste Ausgangstransistor (1) als bipolarer Transistor in Emitterschaltung ausgebildet ist.

3. Schaltungsanordnung nach Anspruch 1 oder 2,
**dadurch gekennzeichnet, daß** die Kompensationsanordnung (2,9,12,13,17) einen zweiten Ausgangstransistor (2) aufweist, dessen Hauptstrompfad mit einem seiner Enden an den ersten Verbindungspunkt (7) und mit seinem zweiten Ende an einen Steueranschluß des ersten Ausgangstransistors (1) angeschlossen ist.

4. Schaltungsanordnung nach Anspruch 3,
**dadurch gekennzeichnet, daß** der erste und der zweite Ausgangstransistor (1,2) mit gegenphasigen Wechselstrom-Steuersignalen (von 18,19) beaufschlagbar sind.

5. Schaltungsanordnung nach Anspruch 4,
**dadurch gekennzeichnet, daß** die gegenphasigen Wechselstrom-Steuersignale (von 18,19) von gegenphasig gespeisten Ausgängen einer gemeinsamen Signalquelle ableitbar sind.

6. Schaltungsanordnung nach Anspruch 4 oder 5,
**dadurch gekennzeichnet, daß** der erste Ausgangstransistor (1) als Ausgangszweig einer ersten Stromspiegelanordnung (1,8,10,11,16) fungiert, die weiterhin
- einen ersten Eingangstransistor (8), dessen Steueranschluß mit dem Steueranschluß des ersten Ausgangstransistors (1) und dessen Hauptstrompfad einseitig mit dem ersten Verbindungspunkt (7) verbunden ist,
- eine erste Gleichstromquelle (10) zwischen dem Steueranschluß des ersten Ausgangstransistors (1) und dem ersten Verbindungspunkt (7),
- eine zweite Gleichstromquelle (11) zum Speisen eines zweiten Gleichstromes über einen zweiten Verbindungspunkt (14) in den Hauptstrompfad des ersten Eingangstransistors (8) sowie
- einen ersten Treibertransistor (16) aufweist, dessen Hauptstrompfad einseitig mit dem Steueranschluß des ersten Ausgangstransistors (1) verbunden ist und dessen mit dem zweiten Verbindungspunkt (14) verbundenem Steueranschluß eines der Wechselstrom-Steuersignale zuleitbar ist,
und daß der zweite Ausgangstransistor (2) als Ausgangszweig einer zweiten Stromspiegelanordnung (2,9,12,13,17) fungiert, deren Aufbau mit dem der ersten Stromspiegelanordnung (1,8,10,11,16) übereinstimmt, wobei an einem Steueranschluß eines dem ersten Treibertransistor (16) entsprechenden zweiten Treibertransistors (17) das zweite gegenphasige der Wechselstrom-Steuersignale zuleitbar ist.

7. Schaltungsanordnung nach einem der vorhergehenden Ansprüche, **gekennzeichnet durch** eine vollständige Integration auf einem Halbleiterkörper, wobei die parasitäre Induktivität (5) **durch** eine Zuleitung zwischen dem Halbleiterkörper und einer außerhalb desselben vorgegebenen, das Bezugspotential führenden Leiteranordnung bestimmt ist.

## Claims

1. A circuit arrangement having an output current path coupled between an output terminal (3) and a conductor configuration (4) carrying a reference potential and a main current path of a first output transistor (1) for supplying an alternating signal current to the output terminal (3), **characterized in that** there is provided a compensation circuit (2, 9, 12, 13, 17, 19, 21), which compensates for the influence of a parasitic inductance (5) in the coupling between the output current path and the conductor configuration (4) carrying the reference potential **in that** an alternating compensation current can be applied to a first node (7) between the output current path and the parasitic inductance (5), which compensation current is in phase opposition to and of at least substantially the same magnitude as the alternating signal current.

2. A circuit arrangement as claimed in Claim 1, **characterized in that** the first output transistor (1) is a bipolar transistor in grounded emitter connection.

3. A circuit arrangement as claimed in Claim 1 or 2, **characterized in that** the compensation circuit (2, 9, 12, 13, 17) comprises a second output transistor (2) having one end of its main current path connected to the first node (7) and having its second end connected to a control terminal of the first output transistor (1).

4. A circuit arrangement as claimed in Claim 3, **characterized in that** the first and the second output transistor (1, 2) are arranged to receive a.c. control signals (from 18, 19) of opposite phase.

5. A circuit arrangement as claimed in Claim 4, **characterized in that** the a.c. control signals (from 18, 19) of opposite phase can be obtained from outputs of a common signal source, which outputs carry signals of opposite phase.

6. A circuit arrangement as claimed in Claim 4 or 5,
**characterized in that** the first output transistor (1) functions as an output branch of a first current mirror circuit (1, 8, 10, 11, 16), which further comprises
- a first input transistor (8) whose control terminal is connected to the control terminal of the first output transistor (1) and whose main current path has one end connected to the first node (7),
- a first direct current source (10) between the control terminal of the first output transistor (1) and the first node (7),
- a second direct current source (11) for supplying a second direct current into the main current path of the first input transistor (8) via a second node (14), and
- a first driver transistor (16) whose main current path has one end connected to the control terminal of the first output transistor (1) and whose control terminal, which is connected to the second node (14), is arranged to receive one of the a.c. control signals,
and **in that** the second output transistor (2) functions as an output branch of a second current mirror circuit (2, 9, 12, 13, 17) whose construction corresponds to that of the first current mirror circuit (1, 8, 10, 11, 16), a control terminal of a second driver transistor (17), which corresponds to the first driver transistor (16), being arranged to receive the second one of the a.c. control signals, which is of opposite phase.

7. A circuit arrangement as claimed in Claim in as claimed in any one of the preceding Claims, **characterized by** full integration on a semiconductor body, the parasitic inductance (5) being determined by a lead between the semiconductor body and a given conductor configuration which is external to said semiconductor body and which carries reference potential.

## Revendications

1. Circuit avec une voie de courant de sortie qui est couplée entre une borne de sortie (3) et un dispositif conducteur (4) conduisant un potentiel de référence et comprend une voie de courant principal d'un premier transistor de sortie (1) pour fournir un signal de courant alternatif à la borne de sortie (3),
**caractérisé en ce qu'**il est prévu un dispositif de compensation (2, 9, 12, 13, 17, 19, 21) par lequel l'influence d'une inductance parasitaire (5) dans le couplage entre la voie de courant de sortie et le dispositif conducteur (4) conduisant le potentiel de référence est compensée par le fait qu'un courant alternatif de compensation qui est en opposition de phase et d'au moins la même intensité par essence que le signal de courant alternatif peut être amené à un premier point de raccordement (7) entre la voie de courant de sortie et l'inductance parasitaire (5).

2. Circuit selon la revendication 1,
**caractérisé en ce que** le premier transistor de sortie (1) est conçu comme un transistor bipolaire dans le circuit émetteur.

3. Circuit selon l'une des revendications 1 ou 2,
**caractérisé en ce que** le dispositif de compensation (2, 9, 12, 13, 17) présente un deuxième transistor de sortie (2) dont la voie de courant principal est raccordée par l'une de ses extrémités au premier point de raccordement (7) et par sa deuxième extrémité à une borne de commande du premier transistor de sortie (1).

4. Circuit selon la revendication 3,
**caractérisé en ce que** les premier et deuxième transistors de sortie (1, 2) peuvent être alimentés en signaux de commande de courant alternatif (de 18, 19) en opposition de phase.

5. Circuit selon la revendication 4,
**caractérisé en ce que** les signaux de commande de courant alternatif en opposition de phase (de 18, 19) peuvent être dérivés de sorties alimentées en opposition de phase d'une source de signal commune.

6. Circuit selon l'une des revendications 4 ou 5,
**caractérisé en ce que** le premier transistor de sortie (1) fait office de branche de sortie d'un premier dispositif de miroir de courant (1, 8, 10, 11, 16) qui présente par ailleurs
- un premier transistor d'entrée (8), dont la borne de commande est reliée à la borne de commande du premier transistor de sortie (1) et dont la voie de courant principal est reliée d'un côté au premier point de raccordement (7),
- une première source de courant continu (10) entre la borne de commande du premier transistor de sortie (1) et le premier point de raccordement (7),
- une deuxième source de courant continu (11) en vue d'alimenter un deuxième courant continu par l'intermédiaire d'un deuxième point de raccordement (14) dans la voie de courant principal du premier transistor de sortie (8) ainsi
- qu'un premier transistor d'attaque (16) dont la voie de courant principal est reliée d'un côté à la borne de commande du premier transistor de sortie (1) et à la borne de commande reliée au deuxième point de raccordement (14) duquel peut être amené l'un des signaux de commande de courant alternatif.
et que le deuxième transistor de sortie (2) tient lieu de branche de sortie d'un deuxième dispositif de miroir de courant (2, 9, 12, 13, 17) dont la conception correspond au premier dispositif de miroir de courant (1, 8, 10, 11, 16), le deuxième des signaux de commande de courant alternatif en opposition de phase pouvant être amené à une borne de commande d'un deuxième transistor d'attaque (17) correspondant au premier transistor d'attaque (16).

7. Circuit selon l'une des revendications précédentes,
**caractérisé par** une intégration complète sur un corps à semi-conducteurs, l'inductance parasitaire (5) étant déterminée par une ligne entre le corps à semi-conducteurs et un dispositif conducteur conduisant le potentiel de référence et préalablement déterminé en dehors de celui-ci.
